# EUROPEAN PATENT APPLICATION

(11) **EP 1 243 970 A1**
(43) Date of publication of application: **25.09.2002**
(21) Application number: 01302647.1
(22) Date of filing: 22.03.2001
(51) Int. Cl.: G03F 7/20

(54) **Lithographic apparatus**

(71) Applicant: ASML Netherlands B.V., 5503 LA Veldhoven (NL)
(72) Inventor: The designation of the inventor has not yet been filed
(74) Representative: Leeming, John Gerard

(57) **Abstract**

A lithographic apparatus is provided in which an electrically conducting mesh (2) is located above surfaces within it on which a beam of radiation (3) is incident; such surfaces include the substrate, the patterning means, a sensor or a mirror within either the radiation system or the projection system; the mesh has a positive voltage applied to it which attracts electrons freed from the surface.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from United States Patents US 5,296,891 and US 5,523,193, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, incorporated herein by reference.

In a lithographic projection apparatus using EUV radiation, the beam of radiation may cause electrons to be freed from any surface on which it is incident. The surfaces which the beam of radiation is incident on include mirrors in the radiation system and the projection system as well as the substrate, sensors and the patterning means. The electrons in turn may break the bonds in water and CₓH_{y} molecules present on the surfaces, resulting in reactive contaminants that cause damage to the surface. OH, in particular can cause substantial damage. Furthermore, the decomposition of the molecule does not absorb the stray electrons, which can then return to the surface and cause further damage on the surface.

It is an object of the present invention to provide a means of alleviating the problems caused by the liberation of electrons on the surface of components on which a radiation beam is incident.

This and other objects are achieved according to the invention in a lithographic apparatus as specified in the opening paragraph, characterized by at least one electrically conducting mesh, electrically connected to a voltage source which biases the mesh to a voltage at which the mesh attracts electrons; and said electrically conducting mesh is positioned such that, in use, it collects electrons which are freed from a surface on which a beam of radiation, within the apparatus, is incident.

By means of such a mesh, the electrons liberated by the surface by the beam of radiation are collected and therefore prevented from returning to the surface. This reduces the amount of damage done to the surface.

In a preferred embodiment, the electrically conducting mesh is comprised of a plurality of very thin electrically conducting wires. The distance between adjacent wires is substantially greater than the diameter of the wires. This ensures that the mesh does not obscure the beam of radiation.

In a further preferred embodiment, the distance between the wires will be smaller than the distance between the wires and the surface from which the electrons are liberated. This is advantageous since it will result in an approximately uniform electrical field from the wires to the surface.

In a yet further preferred embodiment, the mesh is formed from at least one of tungsten, molybdenum, copper and zirconium or alloys thereof. Zirconium is especially preferred because it is relatively EUV transparent.

Preferably, a mesh of the type described may be used to collect electrons liberated from the surface of the mirrors in the radiation system and the projection system as well as from the substrate and the patterning means.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
characterized by the steps of:
providing an electrically conductive mesh which is biased to a voltage at which the mesh attracts electrons; and
positioning said electrically conducting mesh such that it collects electrons which are freed from a surface on which a beam of radiation is incident.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation *(e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 shows a cross section of a surface with a mesh according to the present invention;
Figure 3 shows, in perspective, a flat surface with a mesh according to the present invention;
Figure 4 shows, in perspective, a curved surface with a curved mesh according to the present invention;

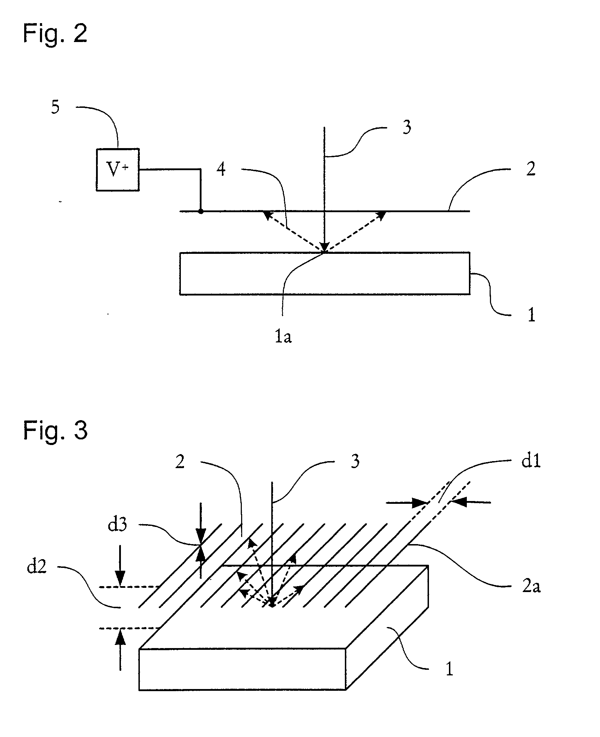

Figure 3 shows, in perspective, a curved surface with a flat mesh according to the present invention.

In the Figures, corresponding reference symbols indicate corresponding parts.

### Embodiment 1

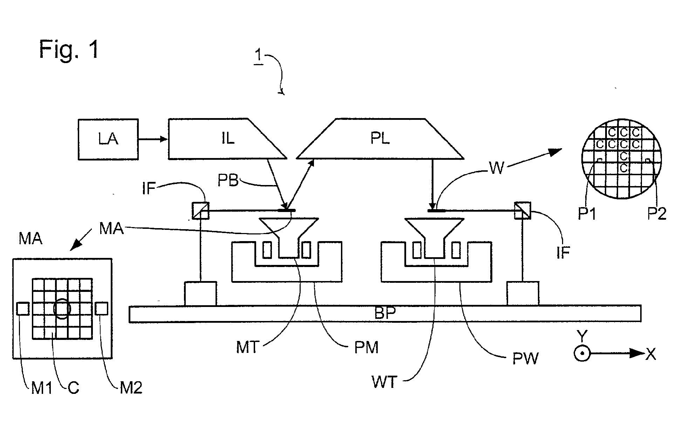

Figure 1 schematically depicts a lithographic projection apparatus 1 according to the present invention. The apparatus comprises:
a radiation system LA, IL for supplying a projection beam PB of *e.g.* EUV radiation;
a first object table (mask table) MT for holding a mask MA (*e.g.* a reticle), and connected to first positioning means PM for accurately positioning the mask with respect to item PL;
a second object table (substrate table) WT for holding a substrate W (*e.g.* a resist-coated silicon wafer), and connected to second positioning means PW for accurately positioning the substrate with respect to item PL;
a projection system ("lens") PL for imaging an irradiated portion of the mask MA onto a target portion C (die) of the substrate W. As here depicted, the projection system is of a reflective type.

In case a projection beam of EUV radiation is employed, the apparatus will generally provide for a low-pressure environment of some degree of low pressure since gasses tend to absorb the EUV radiation.

The source LA *(e.g.* a laser-produced plasma source, a discharge source, or an undulator or wiggler provided around the path of an electron beam in a storage ring or synchrotron) produces a beam of EUV radiation. This beam is fed into an illumination system (illuminator) IL, either directly or after having traversed conditioning means, such as a beam expander, for example. The illuminator IL may comprise adjusting means for setting the outer and/or inner radial extent (commonly referred to as σ-outer and σ-inner, respectively) of the intensity distribution in the beam. In addition, it will generally comprise various other components, such as an integrator and a condenser. In this way, the beam PB impinging on the mask MA has a desired uniformity and intensity. distribution in its cross-section.

It should be noted with regard to Figure 1 that the source LA may be within the housing of the lithographic projection apparatus, but that it may also be remote from the lithographic projection apparatus, the radiation beam which it produces being led into the apparatus (*e.g.* with the aid of suitable directing mirrors). The current invention and claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library or during a scan. In general, movement of the object tables MT, WT will be realized with the aid of a long-stroke module (course positioning) and a short-stroke module (fine positioning), which are not explicitly depicted in Figure 1.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

1. 2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Figure 2 shows a cross section of an element 1 on the surface 1a of which a beam of radiation 3 is incident. The element 1 may be a substrate W, a patterning means MA, or a mirror within the radiation system IL or the projection system PL. The beam of radiation 3 causes electrons 4 to be liberated from the surface 1a of the element 1.

Mesh 2 is located above the surface 1a of the element 1. Voltage source 5 is connected to the mesh 2 and applies a predetermined positive voltage to the mesh. As a result the liberated electrons 4 are attracted to and collected by the mesh 2.

Figure 3 shows the mesh 2 in perspective. In this case, the mesh is comprised of a plurality of parallel wires 2a. The thickness d3 of each of the wires is substantially smaller than the distance d1 between adjacent wires. This ensures that the mesh does not obscure the beam of radiation. Furthermore, the distance d1 between adjacent wires is smaller than the distance d2 of the wires from the surface 1a of the element 1. This ensures that the electrical field from the wires to the surface is approximately uniform.

A suitable size range for the wires 2a is a thickness d3 of 2 µm to 10 µm. The wires are typically formed from a conductor such as tungsten, molybdenum, copper or zirconium. A particular advantage of zirconium is that it is relatively transparent to EUV. The distance d1 between the wires and the distance d2 of the wires from the surface 1a are both typically of the order of 1 cm.

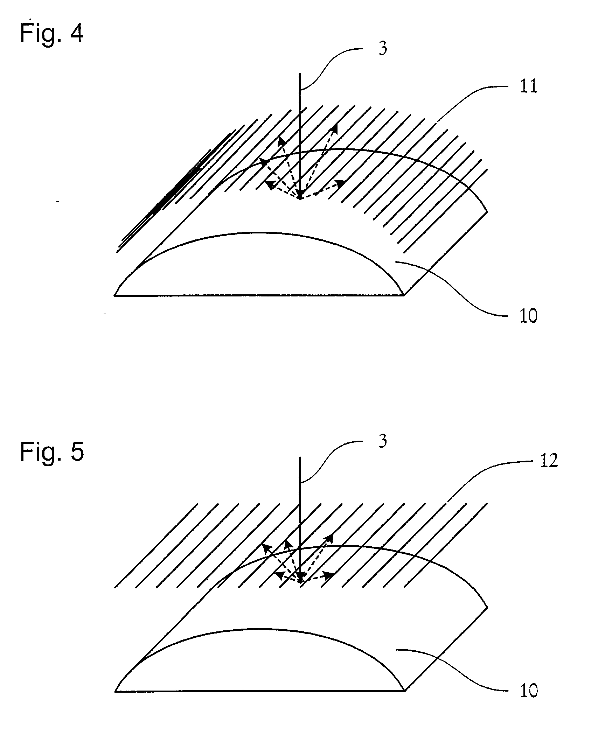

Figures 4 and 5 show the mesh of the present invention in use with a curved element 10. In Figure 4, the mesh 11 is curved such that it approximately follows the curve of the element 10. In Figure 5, the mesh 12 is substantially planar. Although it is possible for the mesh to follow the curvature of the element 10, in order to form a uniform electric field, it is not necessary. In some situations, it may not be possible to position the wires of the mesh to form a curve. In such cases the planar arrangement (as shown in Figure 5) will still be a significant improvement to an element with no mesh.

Whilst specific embodiments of the invention have been described above, it will be appreciated that the invention may be practiced otherwise than as described. The description is not intended to limit the invention.

Specifically, whilst in the above description the mesh has been described as being comprised of a plurality of parallel wires, it will be appreciated that a variety of patterns may be used advantageously. In particular, there may be situations in which anchoring points for the wires of the mesh are limited, necessitating a different pattern.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate,
**characterized by** at least one electrically conducting mesh, electrically connected to a voltage source which biases the mesh to a voltage at which the mesh attracts electrons; and
said electrically conducting mesh is positioned such that, in use, it collects electrons which are freed from a surface on which a beam of radiation, within the apparatus, is incident.

2. A lithographic projection apparatus according to claim 1, wherein the electrically conducting mesh is comprised of a plurality of electrically conducting wires; and
the wires have a diameter which is smaller than the distance between adjacent wires;
preferably, the diameter of the wires is at least 100 times smaller than the distance between adjacent wires; more preferably, the diameter of the wires is more than 1,000 times smaller than the distance between adjacent wires.

3. A lithographic projection apparatus according to claim 2, wherein the distance between adjacent electrically conducting wires is smaller than the distance from the wires to the surface from which the electrons are freed.

4. A lithographic projection apparatus according to claim 2 or 3, wherein the electrically conducting wires have a diameter not larger than 10 µm.

5. A lithographic projection apparatus according to any one of claims 1 to 4, wherein at least part of the electrically conducting mesh is formed from at least one of tungsten, molybdenum, copper and zirconium or an alloy thereof.

6. A lithographic projection apparatus according to any one of claims 1 to 5, wherein the surface on which a beam of radiation is incident is at least one of the surface of the substrate, the patterning means, a sensor, a mirror within the radiation system and a mirror within the projection system.

7. A lithographic projection apparatus according to any one of claims 1 to 6, wherein the surface on which a beam of radiation is incident is curved and the electrically conducting mesh has at least some curvature corresponding to that of the surface on which a beam of radiation is incident.

8. An apparatus according to any preceding claim, wherein the support structure comprises a mask table for holding a mask.

9. An apparatus according to any preceding claim, wherein the radiation system comprises a radiation source.

10. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
**characterized by** the steps of:
providing an electrically conductive mesh which is biased to a voltage at which the mesh attracts electrons; and
positioning said electrically conducting mesh such that it collects electrons which are freed from a surface on which a beam of radiation is incident.

11. A device manufactured according to the method of Claim 10.
